# EUROPEAN PATENT APPLICATION

(11) **EP 0 700 239 A1**
(43) Date of publication of application: **06.03.1996**
(21) Application number: 95305910.2
(22) Date of filing: 23.08.1995
(51) Int. Cl.: H05K 3/34, H05K 1/09, H01L 23/495, B23K 35/00, B23K 35/26

(54) **Articles including solderable zinc surfaces**

(30) Priority: 31.08.1994 US 299471
(71) Applicant: AT&T Corp., New York, NY 10013-2412 (US)
(72) Inventor: Degani, Yinon, Highland Park, New Jersey 08904 (US); Law, Henry Hon, Berkeley Heights, New Jersey 07922 (US); Jin, Sungho, Millington, New Jersey 07946 (US); McCormack, Mark Thomas, Summit, New Jersey 07901 (US)
(74) Representative: Johnston, Kenneth Graham

(57) **Abstract**

The present invention relates to solderable surfaces and surface finishes which comprise zinc. An electrical article is provided comprising a non-conductive substrate for supporting electric device elements. At least one electrical device element is disposed on the non-conductive substrate. At least one metallized region is formed on the non-conductive substrate, the metallized region electrically communicating with the electrical device element. The metallized region comprises a layer which includes zinc. Typically, the zinc is provided in the form of a zinc-containing alloy. In a further embodiment, the present invention provides electrical components having an electrical connection element which includes a zinc-containing surface.

## Description

### Field of the Invention

The invention relates to articles having solderable surfaces and, more particularly, to electrical articles including highly solderable zinc surfaces for adhering to both lead-containing and lead-free solders.

### Background of the Invention

Solder bonding is a critical step in many industrial processes, particularly in the interconnection and packaging of electronic devices. Currently, the most widely-used solders are based on the eutectic 63 wt.% Sn- 37 wt.% Pb alloy. This Sn-based solder is most frequently used to provide a bond between copper surfaces. The 63% Sn-37% Pb alloy becomes molten at approximately 183°C and spreads well, wetting clean copper surfaces. Because surface copper oxides inhibit spreading of the molten solder, copper surfaces are often protected from oxidation by thin coatings (e.g., organic coatings, tin, gold). Additionally, various fluxes are used in the soldering process to remove any residual surface oxides and enhance wetting of the surface by the solder.

While soldering with lead-based alloys is an established art, environmental considerations have focused recent attention on lead-free alloys for assembly of electrical devices. Lead-free solders are discussed in a series of article in J. Metals, July, 1993, and in J. Elect. Mater., August, 1994. Lead-free solders are further described in co-pending U.S. Patent Application Serial Nos. 08/021,005, 08/201,603, and 08/255,687, and 08/284,028 the disclosures of which are incorporated by reference herein. Although lead-free solders are attractive from an environmental standpoint, they do not exhibit the same propensity to spread and wet copper surfaces to a satisfactory level as do lead-containing solders. This is particularly true for lead-free solders which include zinc.

Thus, there is a need in the art for electrical article surfaces which are highly solderable by lead-free solders. There is a further need for article surfaces which are highly solderable by both lead-free and lead-containing solders, in order to facilitate device manufacture. Such surfaces could be employed in electrical devices such as printed wiring boards and electrical component connection elements.

### Summary Of The Invention

The present invention relates to electrical articles having solderable surfaces and surface finishes which include zinc. Surprisingly, it has been discovered that zinc surfaces are solderable by both lead-containing and lead-free solder alloys. In accordance with the present invention, there is provided an electrical article comprising a non-conductive substrate for supporting electrical device elements. At least one electrical device element is disposed on the non-conductive substrate. This device element includes, but is not limited to, circuit lines, surface-mountable components, semiconductor devices, resistors, capacitors, transformers, inductors, and/or modules or packages which include any of these elements. At least one metallized region is formed on the non-conductive substrate, the metallized region electrically communicating with the electrical device element. The metallized region comprises a layer which includes zinc. Typically, the zinc is provided in the form of a zinc-containing alloy. Optionally, the metallized region includes an initial layer of high-conductivity metal including, but not limited to, copper, silver, nickel, palladium, gold, aluminum or combinations thereof on which the zinc-containing layer is formed.

In a further embodiment, the present invention relates to electrical components capable of being soldered with a lead-free alloy. The electrical component includes at least one electrical connection element, the electrical connection element configured for electrical attachment to an electrical device or a substrate through a soldering process. The electrical connection element is provided with a layer comprising zinc on an exterior surface of the electrical connection element in a region which contacts a solder. Typically, the electrical component is a resistor, capacitor, semiconductor device assembly, inductor, transformer, or other surface-mountable component.

### Brief Description Of The Drawings

FIG. 1 is a photomicrograph of a solder region showing the area of spread of 87 wt.% Sn- 8 wt. % Zn- 5 wt.% In on a Zn-coated copper surface.

FIG. 2 is a photomicrograph of a solder region showing the area of spread of 63 wt.% Sn- 37 wt. % Pb on a Zn-coated copper surface.

FIG. 3 is a photomicrograph of a solder region showing the area of spread of 87 wt.% Sn- 8 wt. % Zn- 5 wt.% In on a copper surface.

FIG. 4 is a photomicrograph of a solder region showing the area of spread of 63 wt.% Sn- 37 wt.% Pb on a copper surface.

### Detailed Description

The present invention provides electrical articles with zinc-containing surface finishes which are solderable by both lead-containing and lead-free solder alloys. The discovery that zinc-containing surfaces are compatible with such solder alloys is particularly surprising in view of the longstanding teaching in the solder assembly art against the presence of zinc on solderable surfaces, such as copper. The soldering literature is replete with warnings against the presence of metallic zinc in soldering processes. For example, it is recommended in "Surface Preparation" from the Electronic Materials Handbook, (ASM International, Metals Park, OH) c. 1989, p. 679, that barrier plating (e.g., with copper) should always be performed over brass to prevent zinc diffusion from deleteriously affecting the solderabilty of the surface. Also, "Fluxes and Flux Action" from The Mechanics of Solder Alloy Wetting and Spreading, (Van Nostrand Reinhold, N.Y.), c. 1993, pp. 88-92 discusses the effect of solder impurities on solderability, stating that zinc is the most detrimental impurity affecting solder wetting in 63 wt.% Sn- 37 wt.% Pb. Zinc concentrations as low as 0.04 wt.% were found to reduce the area of spread for molten solder on brass by 25 %.

According to the present invention, electrical articles on which a soldering step is to be performed are provided with a zinc-containing layer. Typically, the thickness of the zinc-containing layer is 0.05-100 microns, preferably 0.1-75 microns, and even more preferably 0.5-50 microns. Electrical articles which are provided with the zinc-containing layer include non-conductive substrates. The expression "non-conductive substrate" as used herein includes those substrates which are insulating, such as printed circuit substrates of ceramic, polymer, and fiber-reinforced polymer, as well as conductive materials which include at least one insulating layer upon which device elements are supported. Such substrates generally support electrical devices, components, and circuit lines. Metallized regions of these substrates serve as bonding pads for device and component attachment. As such, these metallized regions electrically communicate with other electrical devices, components, and circuit lines which are supported by the substrate.

According to the present invention, a metallized substrate region includes a layer of zinc or a zinc-containing alloy. Optionally, this metallized region includes an initial layer of high-conductivity metal including, but not limited to, copper, silver, nickel, palladium, gold, aluminum or combinations thereof on which the zinc-containing layer is formed.

In a further embodiment of the invention, the zinc-containing layers are provided on electrical component connection elements such as leads to enhance solderability. Electrical components such as resistors, capacitors, semiconductor device packages, modules, inductors, transformers, and the like can include a zinc-containing layer on their connectors (e.g., leads, pins, bonding pads, and the like) to improve the solder bond according to the present invention.

Numerous alloy compositions can be employed for the zinc-containing layers of the present invention. When the zinc is primarily alloyed with elements possessing lower melting temperatures than zinc (e.g., tin, lead), the amount of zinc is at least 0.25% by weight of the alloy, preferably greater than 0.5%, more preferably greater than 1.0%, and even more preferably greater than 2.0%. When alloyed primarily with elements possessing higher melting points than zinc (e.g., copper, gold, nickel, aluminum, and silver), the amount of zinc is preferably at least 5% by weight, more preferably greater than 30%, and even more preferably greater than 90%.

The zinc-containing layers are deposited on electrical articles through any known coating technique. Such techniques include, but are not limited to, electrochemical processes such as electroplating, electroless plating, electrophoresis, chemical vapor deposition, physical vapor deposition process such as evaporation, sputtering, and ion plating, molten metal or plasma spraying, liquid immersion, diffusion bonding, and deformation bonding. Optionally, the zinc-containing layer is deposited such that there is some surface roughness, typically having a range from 1-100 microns in peak-to-valley variation from the mean surface. Such surface roughness promotes the flow of solder along the surface to enhance spreading and wetting.

Optionally, the zinc-containing layer is provided with a thin protective surface finish of an organic, inorganic, or metallic material. Such surface finishes shield the underlying zinc-containing layer from corrosion; excess surface oxides impede wetting of molten solders on the zinc-containing surfaces. The protective surface finish is made substantially thinner than the zinc-containing layer to prevent it from interfering with the soldering process.

When using organic coatings for the protective surface finish, the organic material selected is either hermetic or complexing. Hermetic coatings, such as rosin, are applied as a dilute solution and dried. The dried rosin is water-resistant, retarding oxidation of the zinc-containing layer. Organic complexing coatings, such as imidazole and benzotriazole, are similarly applied in the form of a solution followed by drying. The complexing organics form a surface monolayer of a metal-organic complex that is energetically more favored than oxide formation, retarding oxidation of the zinc-containing layer. The organic coatings are heat-sensitive and hence are relatively easily removed from the zinc-containing layers during soldering.

As stated previously, the zinc-containing layers of the present invention are compatible for soldering with both lead-containing and lead-free solders. Preferred lead-containing solders are those based on the tin-lead system with solders of 63 wt.% Sn-37 wt.% Pb being exemplary. Preferred lead-free solders include those based on the tin-silver system, tin-gold, tin-bismuth, tin-copper, tin-indium, and tin-zinc based binary, ternary, or higher-order alloy systems. Examples of particular solders are described in U.S. Patent Application Serial Nos. 08/021,005, 08/201,603, and 08/255,687, and 08/284,028.

Soldering to the zinc-containing layers can be performed using any of a variety of soldering techniques. Such soldering techniques include, but are not limited to, surface mount reflow soldering, wave soldering, laser soldering, and manual soldering as by solder iron, or oven-heating and hot plate systems. The solders are applied to the electrical device to be soldered using bulk solder preforms (e.g., solder wires, bars, foils) during the soldering process or they are applied to the substrate prior to the soldering process. For example, solder-containing powders are applied as a paste or suspension in a pattern to regions requiring solder bonding.

For printed solder features of a given area and height, solder spreading (e.g., during reflow soldering) can be defined as the percent change in solder/substrate contact area in the as-deposited and reflowed conditions. For a printed feature of 0.25 in. diameter and 0.10 in. height, good wetting and spreading occurs if the reflowed contact area is at least one-half the original area, more preferably at least 75% of the original area, even more preferably 90% of the original area, and most preferably, equal to or greater than the original area.

The following Examples demonstrate the spread of solders on zinc-containing layers. Following the Examples are Comparative Examples demonstrating the spread of solders on substrates without zinc-containing layers.

### EXAMPLE 1:

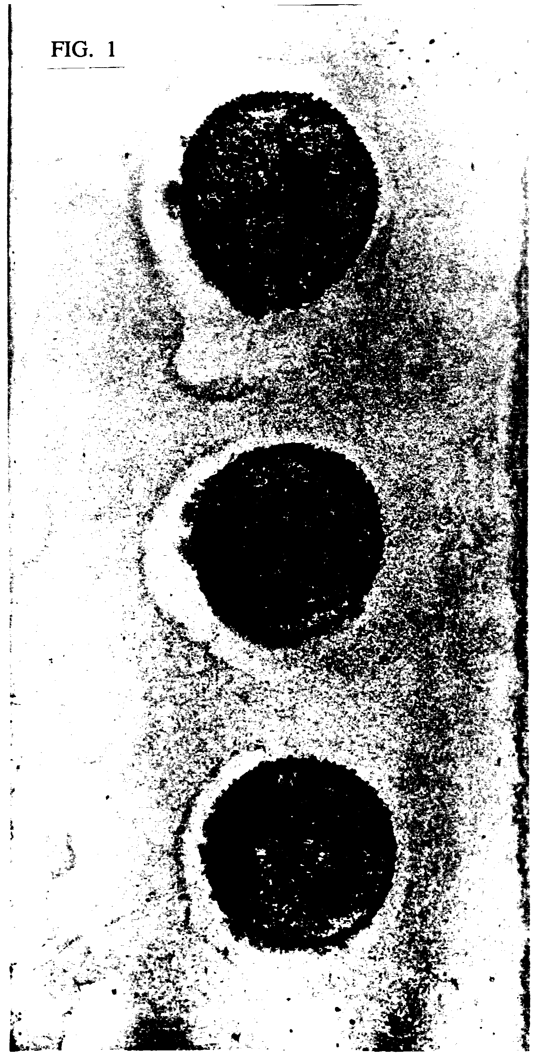

A lead-free solder paste comprising 87 wt.% Sn- 8 wt.% Zn- 5 wt.% In solder powder (-200 +325 mesh) and an RMA-type (mildly activated rosin) flux was screen printed on copper-laminated FR-4 (fiber-reinforced epoxy) printed wiring board that was electroplated with approximately 50 microns of zinc. The solder feature was approximately 0.25 in. diameter and 0.10 in. height. This assembly was heated to approximately 245°C in a nitrogen atmosphere for approximately two minutes. The area of molten solder spread is illustrated in Fig. 1, demonstrating good spreading and good wetting of the zinc-containing layer as evidenced by the absence of balling. The reflowed solder contact area is greater than the printed area of the solder paste.

### EXAMPLE 2:

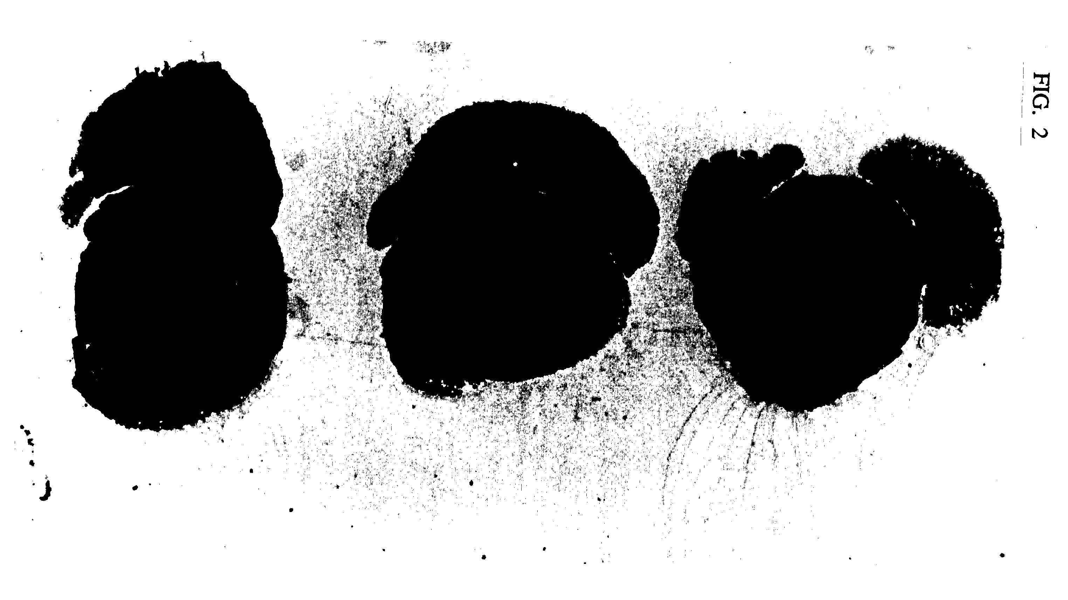

A solder paste comprised of 63 wt.% Sn- 37 wt.% Pb solder powder (-200 +325 mesh) and an RMA-type flux was screen printed on copper-laminated FR-4 printed wiring board which was electroplated with approximately 50 microns of zinc. The solder feature was approximately 0.25 in. diameter and 0.10 in. height. This assembly was heated to approximately 245°C in a nitrogen atmosphere for approximately two minutes. The area of molten solder spread is illustrated in FIG. 2, demonstrating good spreading and wetting, comparable to that of the unplated copper in Comparative Example 2.

### COMPARATIVE EXAMPLE 1:

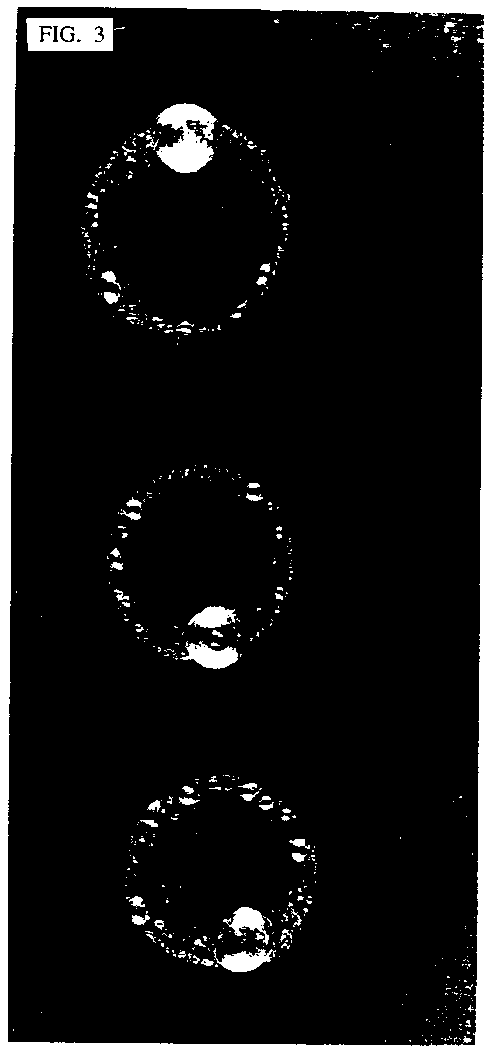

A lead-free solder paste comprising 87 wt.% Sn-8 wt.% Zn- 5 wt.% In solder powder (-200 +325 mesh) and an RMA-type flux was screen printed on copper-laminated FR-4 printed wiring board. The solder feature was approximately 0.25 in. diameter and 0.10 in. height. This assembly was heated to approximately 245°C in a nitrogen atmosphere for approximately two minutes. The area of molten solder spread is illustrated in FIG. 3. As illustrated in FIG. 3, the area of solder spread and degree of wetting are unacceptable for good bond formation. The solder forms balls on the copper surface, indicating poor wetting and poor adhesion of the solder to the underlying copper. The contact area of the reflowed solder is less than 50% of the originally-printed area.

### COMPARATIVE EXAMPLE 2:

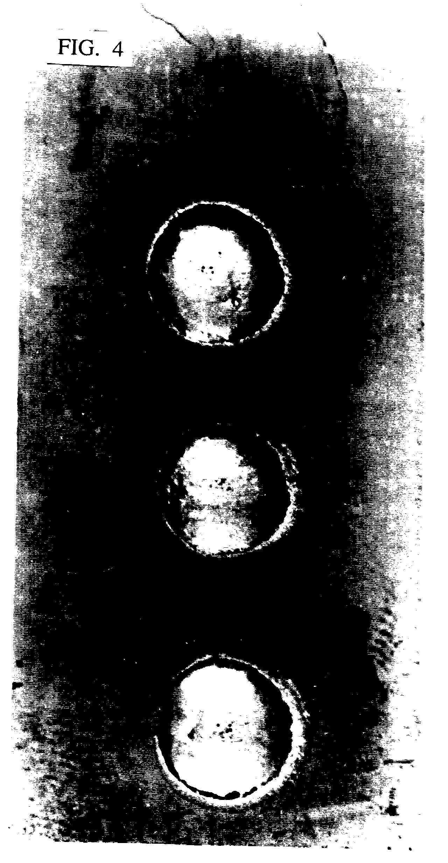

A solder paste comprising 63 wt.% Sn- 37 wt.% Pb powder (-200 +325 mesh) and an RMA-type flux was screen-printed on copper-laminated FR-4 printed wiring board. The solder feature was approximately 0.25 in. diameter and 0.10 in. height. This assembly was heated to approximately 245°C in a nitrogen atmosphere for approximately two minutes. The area of molten solder spread is illustrated in FIG. 4, demonstrating adequate wetting acceptable for solder bonding.

While the foregoing invention has been described in terms of the above detailed embodiments, it will be readily apparent to those skilled in the art that various additions and changes can be made. Accordingly, modifications such as those suggested above, but not limited thereto, are considered to be within the scope of the claimed invention.

## Claims

1. An electrical article comprising:
a non-conductive substrate;
at least one electrical device element disposed on the non-conductive substrate;
at least one metallized region formed on the non-conductive substrate, the metallized region having a solderable layer including zinc; and
a lead-free solder, wherein the solderable layer is soldered to the electrical device element with the lead-free solder.

2. An electrical article comprising:
a non-conductive substrate;
at least one electrical device element disposed on the non-conductive substrate;
at least one metallized region formed on the non-conductive substrate, the metallized region comprising at least one layer including a conductive metal and a solderable layer including zinc; and
a lead-free solder, wherein the solderable layer is soldered to the electrical device element with the lead-free solder.

3. An electrical component having at least one electrical connection element extending therefrom, the electrical connection element configured for electrical attachment to an electrical device through a soldering process, the component comprising:
providing a layer on an exterior surface of the electrical connection element in a region which contacts a lead-free solder, the layer including zinc.

4. An electrical article according to claim 1 or 2, wherein the non-conductive substrate is selected from ceramic, polymeric, and fiber-reinforced polymeric materials.

5. An electrical article according to claim 1 or 2, wherein the nonconductive substrate is a printed wiring board.

6. An electrical article according to claim 1 or 2, further comprising a protective layer disposed on the metallized region, said protective layer optionally including zinc, for example a zinc containing alloy.

7. An electrical article according to claim 1 or 2, or a component according to claim 3, wherein the protective layer includes an organic material, or a metal.

8. An electrical article according to claim 2, wherein the conductive metal includes copper, silver, palladium, gold, nickel, aluminum, and mixtures thereof.

9. An electrical component according to claim 3, wherein the component is a resistor, capacitor, semiconductor device assembly, inductor, transformer, module, or package.

10. An electrical article according to claim 1 or 2, or a component according to claim 3, wherein the lead-free solder is a tin-zinc based solder.
